# EUROPEAN PATENT APPLICATION

(11) **EP 3 657 492 A1**
(43) Date of publication of application: **27.05.2020**
(21) Application number: 17918617.6
(22) Date of filing: 02.11.2017
(51) Int. Cl.: G09G 3/36

(54) **DISPLAY PANEL AND CONTROL METHOD FOR GATE SIGNAL THEREOF**

(30) Priority: 19.07.2017 CN 201710592486
(71) Applicant: Shenzhen China Star Optoelectronics Semiconductor Display Technology Co., Ltd., Shenzhen, Guangdong 518132 (CN)
(72) Inventor: ZHANG, Xianming, Shenzhen Guangdong 518132 (CN)
(74) Representative: Petraz, Gilberto Luigi
(86) International application number: PCT/CN2017/109094
(87) International publication number: WO 2019/015167

(57) **Abstract**

Provided is a control method for a gate signal of a display panel, comprising: electrically connecting an output terminal of a level shifter (140) to a plurality of gate driving units (130), the level shifter (140) being used to generate a sequence signal and a start signal (S201); controlling the sequence signal to be valid and the start signal to be invalid while a number of sequence signals has not reached a preset value (S202); and controlling the start signal to be valid and the sequence signal to be invalid when the number of sequence signals reaches the preset value (S203). The invention further provides a display panel. The method and display panel enable a circuit of a gate driving substrate (100) inside the panel to perform a complete cycle, such that charge in the circuit can be fully released without generating a high current.

## Description

### FIELD OF INVENTION

The present disclosure relates to the field of display technology, and more particularly to a display panel and gate signal control method for a display panel.

### BACKGROUND OF INVENTION

Gate driver on array (GOA) utilizes TFT circuits in TFT LCDs and a level shifter (level shifter IC), on a circuit board, to generate needed gate signals. The signals generated by the level shifter are controlled by a sequence controller. That is, the sequence controller generates the signals that the level shifter needs, then the level shifter transfers the signals into the signals that a gate driving substrate needs, and processes an evaluating transfer. This method can efficiently save needed numbers of gate ICs and reduce costs.

However, an abnormal output signal may result when the sequence controller switches modes, transfers signals, and interferes. It may cause the GOA circuit in the panel to be unable to finish an entire cycle. This will lead to incapability of releasing electric charge and lead to producing a great amount of electric current.

Therefore, a display panel and gate control signal for a display panel are required for solving problems of present technology.

### SUMMARY OF INVENTION

The object of this disclosure provides a display panel and a gate line driving method for a display panel to make the entire cycle of a GOA circuit complete. Thus, the electric charge in the circuit could be sufficiently released and great amounts of electric current will not be generated.

To solve the above-mentioned problems, the present disclosure provides a display panel comprising:
A gate driving substrate, comprising a pixel array and a circuit laying area near the pixel array, the pixel array comprising pixel units arranged in rows.

A plurality of gate driving units, disposed on the circuit laying area, and configured to output scanning signals to the pixel units of the pixel array through scanning lines, each of the scanning lines corresponding to one row of the pixel units of the pixel array;
A level shifter, configured to generate sequence signals and a starting signal, an output end of the level shifter being coupled to the plurality of gate driving units.

The level shifter is configured to count the number of pulses of the sequence signals, and configured to make the sequence signals valid and make the starting signal invalid when the number of pulses of the sequence signals is less than a predetermined number, and configured to make the starting signal valid and make the sequence signals invalid when the number of pulses of the sequence signals reaches a predetermined number.

The level shifter comprises: a counter, a sequence control module, and a starting control module.

The counter is configured to count the number of pulses of the sequence signals and generate a control signal.

A first input end of the sequence control module coupled to an output end of the counter, for receiving the control signal and a sequence input signal, and for generating a sequence enable signal to output the sequence signals to the plurality of gate driving units.

A first input end of the starting control module coupled to the output end of the counter, for receiving the control signal and a starting input signal and, for generating a starting enable signal to output the starting enable signal to the plurality of gate driving units.

In the display panel of present disclosure, the sequence control module comprises a NOT-gate and a first AND-gate.

An input end of the NOT-gate coupled to the output end of the counter, an output end of NOT-gate coupled to a first input end of the first AND-gate, a second input end of the first AND-gate receives the sequence input signal.

In the display panel of present disclosure, the starting control module comprises a second AND-gate.

A first input end of the second AND-gate coupled to the output end of the counter, a second input of the second AND-gate receives the starting input signal.

To solve the above-mentioned problems, the present disclosure further provides a display panel comprising:

A gate driving substrate, comprising a pixel array and a circuit laying area near the pixel array, the pixel array comprising pixel units.

A plurality of gate driving units, disposed on the circuit laying area, and configured to output scanning signals to the pixel units of the pixel array.

A level shifter, configured to generate sequence signals and a starting signal, an output end of the level shifter being coupled to the plurality of gate driving units.

The level shifter is configured to count the number of pulses of the sequence signals, and configured to make the sequence signals valid and make the starting signal invalid when the number of pulses of the sequence signals is less than a predetermined number, and configured to make the starting signal valid and make the sequence signals invalid when the number of pulses of the sequence signals reaches a predetermined number.

In the display panel of present disclosure, the level shifter comprises a counter, a sequence control module, and a starting control module.

The counter is configured to count the number of pulses of the sequence signals and generate a control signal.

A first input end of the sequence control module coupled to an output end of the counter, for receiving the control signal and a sequence input signal, and for generating a sequence enable signal to output the sequence signals to the plurality of gate driving units.

A first input end of the starting control module coupled to the output end of the counter, for receiving the control signal and a starting input signal, and for generating a starting enable signal to output the starting enable signal to the plurality of gate driving units.

In the display panel of present disclosure, the sequence control module comprises a NOT-gate and a first AND-gate.

An input end of the NOT-gate coupled to the output end of the counter, an output end of NOT-gate coupled to a first input end of the first AND-gate, a second input end of the first AND-gate receives the sequence input signal.

In the display panel of present disclosure, the starting control module comprises a second AND-gate.

A first input end of the second AND-gate coupled to the output end of the counter, a second input of the second AND-gate receives the starting input signal.

To solve the above-mentioned problems, the present disclosure further provides a gate signal control method for display panel, wherein the display panel comprises a gate driving substrate, a plurality of driving units, and a level shifter; the gate driving substrate comprises a pixel array and a circuit laying area near the pixel array, the pixel array comprises pixel units arranged in rows; the plurality of gate driving units disposed on the circuit laying area for outputting scanning signals to the pixel units of the pixel array.

The control method comprises:
Coupling an output end of the level shifter with the plurality of gate driving units, the level shifter being configured to generate sequence signals and a starting signal; and
Making the sequence signals valid and making the starting signal invalid when the number of pulses of the sequence signals is less than a predetermined number; making the starting signal valid and making the sequence signals invalid when the number of pulses of the sequence signals reaches a predetermined number.

In the display panel of present disclosure, the level shifter comprises a counter, a sequence control module and a starting control module.

The counter is configured to count the number of pulses of the sequence signals, and configured generate a control signal.

A first input end of the sequence control module coupled to an output end of the counter, for receiving the control signal and a sequence input signal, and for generating a sequence enable signal to output the sequence signals to the plurality of gate driving units.

A first input end of the starting control module coupled to the output end of the counter, for receiving the control signal and a starting input signal, and for generating a starting enable signal to output the starting enable signal to the plurality of gate driving units.

In the display panel of present disclosure, the sequence control module comprises a NOT-gate and a first AND-gate.

An input end of the NOT-gate coupled to the output end of the counter, an output end of NOT-gate coupled to a first input end of the first AND-gate, a second input end of the first AND-gate receives the sequence input signal.

In the display panel of present disclosure, the starting control module comprises a second AND-gate.

A first input end of the second AND-gate coupled to the output end of the counter, a second input of the second AND-gate receives the starting input signal.

In comparison with present technologies, the benefits of present disclosure comprise: the level shifter counts the number of pulses of the sequence signals and makes the sequence signals valid and makes the starting signal invalid when the number of pulses of the sequence signals is less than a predetermined number, and makes the starting signal valid and makes the sequence signals invalid when the number of pulses of the sequence signals reaches a predetermined number. Therefore, the GOA circuits of panels can complete an entire cycle in order to release the electric charge in the circuit sufficiently, and then great amounts of electric current will not be generated.

To make the above-mentioned content become obvious and easy to understand, preferable embodiments will be listed with drawings. The details of the illustrations are as follows.

### DESCRIPTION OF DRAWINGS

The technological methods and other benefits will become obvious by the detailed description together with particular embodiments of the present disclosure.
FIG. 1 illustrates a structure of a display panel of an embodiment of the present disclosure.
FIG. 2 illustrates signal waveforms of an existing level shifter.
FIG. 3 illustrates signal waveforms of a level shifter of an embodiment of the present disclosure.
FIG. 4 illustrates outer pins of the level shifter of an embodiment of the present disclosure.
FIG. 5 illustrates inner circuits of the level shifter of an embodiment of the present disclosure.
FIG. 6 illustrates a flowchart of the control method of gate signals for a display panel of an embodiment of the present disclosure.

### DETAILED DESCRIPTION OF PREFERRED EMBODIMENTS

The illustrations of the following embodiments take the attached drawings as reference to indicate the applicable specific examples of the present disclosure.

The mentioned directional terms, such as center, transverse, upper, lower, left, right, vertical, horizontal, top, bottom, inner, outer, side, etc., are only directions by referring to the accompanying drawings, and thus the used directional terms are used to describe and understand the present invention, Thus, the present invention is not limited thereto. In addition, the terms "first" or "second" are only descriptive, not for indicating the relevant importance or the numbers of technical features. Therefore, the features containing "first" and "second" could be indicative inclusion of one or more such features. In the description of present disclosure, "plurality" means two or more, unless there are additional instructions. The term "includes" and its varieties cover other non-exclusive possibilities.

In the description of the present disclosure, it should be noted that the terms "install", "connect", and "link" should be understood in a broader explanation, unless specifically limited, such as fixed or removable connections, integrated connections, mechanical or electrical connections, be directly connected or be indirectly connected through an intermediate medium, or an internal connection of two elements. For a skilled person in the art, the specific meanings of the above terms in the present disclosure can be understood.

The terms herein are for describing particular embodiments instead of limiting exemplary embodiments. The singular terms "a", "an", or "one" tend to cover plurality, unless the contexts indicated definitely. It should also be understood that the terms "comprise" and/or "include" are for indicating the existing of features, numbers, steps, methods, units, and/or components, not for excluding the existence or addition of other features, numbers, steps, methods, units, components, and/or their combination.

In the drawings, units having similar structures are numbered the same.

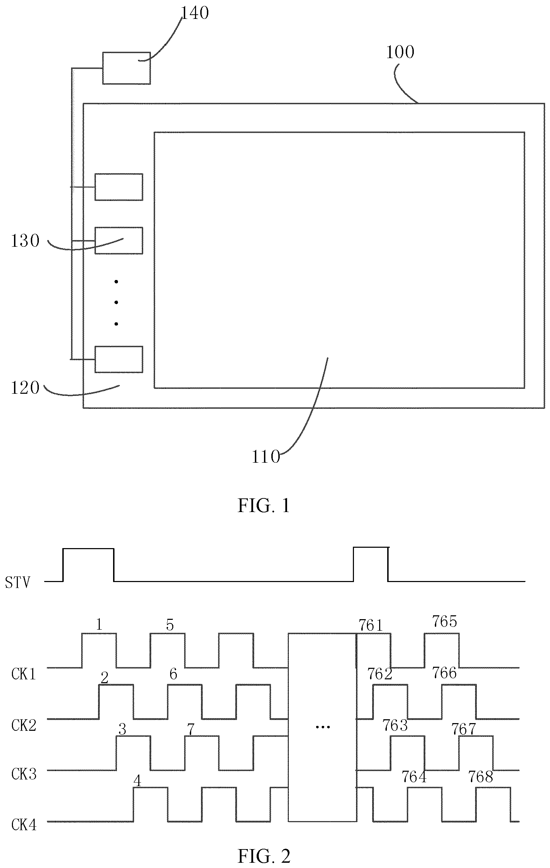

FIG. 1 to FIG. 6 illustrate a display panel and the manufacture procedure of embodiments of present disclosure.

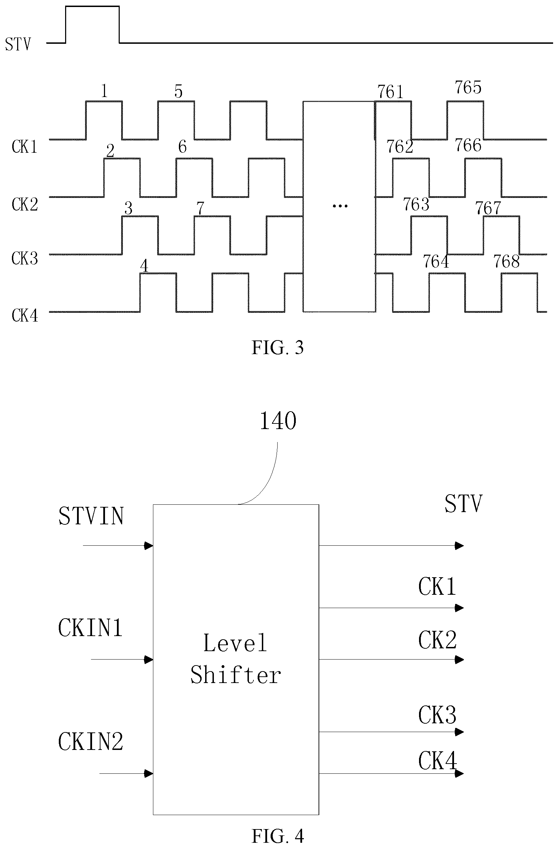

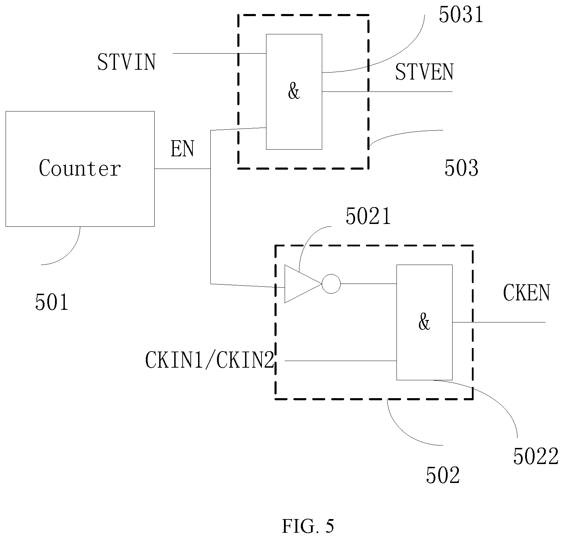

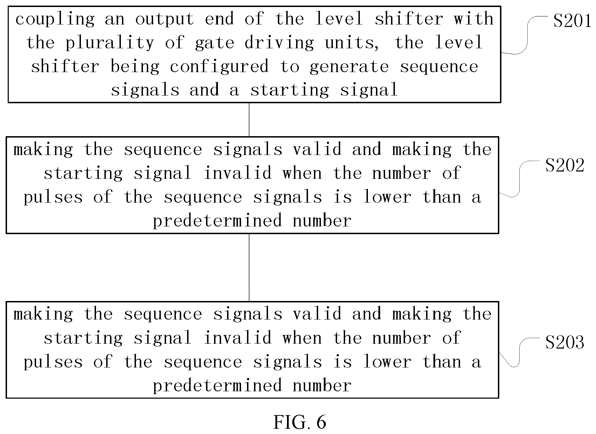

According to the embodiments of present disclosure, as shown in Fig. 1 to Fig. 6, FIG. 1 illustrates a structure of a display panel of an embodiment of the present disclosure, FIG. 2 illustrates signal waveforms of an existing level shifter, FIG. 3 illustrates signal waveforms of a level shifter of an embodiment of the present disclosure, FIG. 4 illustrates outer pins of the level shifter of an embodiment of the present disclosure, FIG. 5 illustrates inner circuits of the level shifter of an embodiment of the present disclosure, and FIG. 6 illustrates a flowchart of the control method of gate signals for a display panel of an embodiment of the present disclosure.

Please refer to Fig. 1, the present embodiments disclose a display panel which includes a gate driving substrate 100, a plurality of gate driving units 130, and a level shifter 140.

The gate driving substrate 100 includes a pixel array 110 and a circuit laying area 120 near the pixel array 110. The pixel array includes a plurality of rows of pixel units. The plurality of gate driving units 130 are disposed on the circuit laying area 120, and are configured to output scanning signals to the pixel units of the pixel array 110. The level shifter 140 is configured to generate sequence signals and a starting signal. An output end of the level shifter is coupled to the plurality of gate driving units 130.

The level shifter is configured to count the number of pulses of the sequence signals. The level shifter makes the sequence signals valid and makes the starting signal invalid when the number of pulses of the sequence signals is less than a predetermined number. The level shifter makes the starting signal valid and makes the sequence signals invalid when the number of pulses of the sequence signals reaches a predetermined number.

It should be indicated that the level shifter in the display panel of the preferable embodiments possesses an addition counting function, in comparison with the existing level shifter, for counting the number of pulses of the sequence signals. The completeness of each frame cycle therefore is guaranteed by counting the number of generated pulses of the sequence signals.

The preferable embodiments of present disclosure utilize the level shifter to count the number of pulses of the sequence signals. The level shifter makes the sequence signals valid and makes the starting signal invalid when the number of pulses of the sequence signals is less than a predetermined number. The level shifter makes the starting signal valid and makes the sequence signals invalid when the number of pulses of the sequence signals reaches a predetermined number. Therefore, the GOA circuit in the panel is able to complete an entire frame cycle, so that the electric charge in the circuit can be released sufficiently and no large amount of electric current will occur.

Take high definition (HD) devices for example. As shown in FIG. 2, an entire display cycle includes a starting signal for pulses and 192 pulses of the sequence signals. It shows that the next starting signal comes during the 191st sequence signals, that is, before the 192nd sequence signals. The entire cycle will not be completed. Hence the electric charges in some circuits will not be released, and large amounts of electric current will occur.

Please refer to FIG. 3, the present embodiments utilize the default control functions of the level shifter. The level shifter is utilized to count the number of pulses of the sequence signals. The level shifter makes the sequence signals valid and makes the starting signal invalid when the number of pulses of the sequence signals is less than a predetermined number. The level shifter makes the starting signal valid and makes the sequence signals invalid when the number of pulses of the sequence signals reaches a predetermined number. Therefore, the GOA circuit in the panel is able to complete an entire frame cycle, so that the electric charge in the circuit can be released sufficiently and no large amount of electric current will occur.

Please refer to FIG. 4 and FIG. 5. The level shifter includes a counter 504, a sequence control module 502, and a starting control module 503. The counter 501 is utilized to count the number of pulses of the sequence signals CK1, CK2, CK3, and CK4, and utilized to generate a control signal EN. A first input end of the sequence control module 502 is coupled to an output end of the counter 501 for receiving the control signal EN and the sequence signal CKIN1 or CKIN2, and for generating a enable signal CKEN to manage the sequence signals CK1, CK2, CK3, or CK3 to output to a plurality of gate driving units 130. A first input end of the starting control module 503 is coupled to an output end of the counter 201 for receiving the control signal EN and a starting input signal STVIN, and for generating a starting enable signal STVEN to manage the starting single STV to output to the plurality of gate driving units 130.

Furthermore, the sequence control module 502 includes a NOT-gate 5021 and a first AND-gate 5022. An input end of the NOT-gate 5021 is coupled to the output end of the counter 501. An output end of NOT-gate 5021 is coupled to a first input end of the first AND-gate 5022. A second input end of the first AND-gate 5022 receives the sequence input signal CKIN1 or CKIN2. The starting control module 503 includes a second AND-gate 2031. A first input end of the second AND-gate 5031 is coupled to the output end of the counter 501. A second input of the second AND-gate 5031 receives the starting input signal STVIN.

Please refer to FIG. 6. The embodiments of present disclosure further disclose a gate signal control method of display panel. The display panel includes a gate driving substrate, a plurality of driving units, and a level shifter. The gate driving substrate comprises a pixel array and a circuit laying area near the pixel array. The pixel array comprises a plurality of rows of pixel units. The plurality of gate driving units are disposed on the circuit laying area for outputting scanning signals to the pixel units of the pixel array.

The control method includes step S201 to step S203.

Step S201: coupling an output end of the level shifter with the plurality of gate driving units, where the level shifter is configured to generate sequence signals and a starting signal.

Step S202: making the sequence signals valid and making the starting signal invalid when the number of pulses of the sequence signals is less than a predetermined number.

Step S203: making the starting signal valid and making the sequence signals invalid when the number of pulses of the sequence signals reaches a predetermined number.

The gate signal control method of display panel of preferable embodiments of present disclosure utilizes the level shifter to count the number of pulses of the sequence signals. The level shifter makes the sequence signals valid and makes the starting signal invalid when the number of pulses of the sequence signals is less than a predetermined number. The level shifter makes the starting signal valid and makes the sequence signals invalid when the number of pulses of the sequence signals reaches a predetermined number. Therefore, the GOA circuit in the panel is able to complete an entire frame cycle, so that the electric charge in the circuit can be released sufficiently and no great amount of electric current will occur.

Furthermore, the level shifter includes a counter, a sequence control module, and a starting control module. The counter is configured to count the number of pulses of the sequence signals, and configured generate a control signal. A first input end of the sequence control module is coupled to an output end of the counter, for receiving the control signal and a sequence input signal, and for generating a sequence enable signal to output the sequence signals to the plurality of gate driving units. A first input end of the starting control module is coupled to the output end of the counter, for receiving the control signal and a starting input signal, and for generating a starting enable signal to output the starting enable signal to the plurality of gate driving units.

The sequence control module includes a NOT-gate and a first AND-gate. An input end of the NOT-gate is coupled to the output end of the counter. An output end of NOT-gate is coupled to a first input end of the first AND-gate. A second input end of the first AND-gate receives the sequence input signal.

The starting control module includes a second AND-gate. A first input end of the second AND-gate is coupled to the output end of the counter. A second input of the second AND-gate receives the starting input signal.

In the display panel and the gate signal control method of display panel of present disclosure, the level shifter is utilized to count the number of pulses of the sequence signals. The level shifter makes the sequence signals valid and makes the starting signal invalid when the number of pulses of the sequence signals is less than a predetermined number. The level shifter makes the starting signal valid and makes the sequence signals invalid when the number of pulses of the sequence signals reaches a predetermined number. Therefore, the GOA circuit in the panel is able to complete an entire frame cycle, so that the electric charge in the circuit can be released sufficiently and no great electric current will occur.

In conclusion, although this disclosure has been disclosed through the preferable embodiments above, the preferable embodiments above are not utilized to limit this disclosure. One having ordinary skills can change and modify without violating the concepts and scope of this disclosure. Therefore, the scope that this disclosure protects is based on the scope defined by the claims.

## Claims

1. A display panel comprising:
a gate driving substrate comprising a pixel array and a circuit laying area near the pixel array, the pixel array comprising pixel units arranged in rows;
a plurality of gate driving units disposed on the circuit laying area, and configured to output scanning signals to the pixel units of the pixel array through scanning lines, each of the scanning lines corresponding to one row of the pixel units of the pixel array;
a level shifter comprising a counter, a sequence control module, and a starting control module, and configured to generate sequence signals and a starting signal, an output end of the level shifter being coupled to the plurality of gate driving units; wherein
the counter is configured to count number of pulses of the sequence signals, and the level shifter is configured to make the sequence signals valid and make the starting signal invalid when the number of pulses of the sequence signals is less than a predetermined number, and configured to make the starting signal valid and make the sequence signals invalid when the number of pulses of the sequence signals reaches a predetermined number;
a first input end of the sequence control module coupled to an output end of the counter, for receiving the control signal and a sequence input signal, and for generating a sequence enable signal to output the sequence signals to the plurality of gate driving units;
a first input end of the starting control module coupled to the output end of the counter, for receiving the control signal and a starting input signal and, for generating a starting enable signal to output the starting enable signal to the plurality of gate driving units.

2. The display panel according to claim 1, wherein the sequence control module comprises a NOT-gate and a first AND-gate;
an input end of the NOT-gate coupled to the output end of the counter, an output end of NOT-gate coupled to a first input end of the first AND-gate, a second input end of the first AND-gate receives the sequence input signal.

3. The display panel according to claim 1, wherein the starting control module comprises a second AND-gate;
a first input end of the second AND-gate coupled to the output end of the counter, a second input of the second AND-gate receives the starting input signal.

4. A display panel, comprising:
a gate driving substrate comprising a pixel array and a circuit laying area near the pixel array, the pixel array comprising pixel units;
a plurality of gate driving units disposed on the circuit laying area, and configured to output scanning signals to the pixel units of the pixel array;
a level shifter configured to generate sequence signals and a starting signal, an output end of the level shifter being coupled to the plurality of gate driving units; wherein
the level shifter is configured to count number of pulses of the sequence signals, and configured to make the sequence signals valid and make the starting signal invalid when the number of pulses of the sequence signals is less than a predetermined number, and configured to make the starting signal valid and make the sequence signals invalid when the number of pulses of the sequence signals reaches a predetermined number.

5. The display panel according to claim 4, wherein the level shifter comprises a counter, a sequence control module, and a starting control module;
the counter is configured to count the number of pulses of the sequence signals and generate a control signal;
a first input end of the sequence control module coupled to an output end of the counter, for receiving the control signal and a sequence input signal, and for generating a sequence enable signal to output the sequence signals to the plurality of gate driving units;
a first input end of the starting control module coupled to the output end of the counter, for receiving the control signal and a starting input signal, and for generating a starting enable signal to output the starting enable signal to the plurality of gate driving units.

6. The display panel according to claim 5, wherein the sequence control module comprises a NOT-gate and a first AND-gate;
an input end of the NOT-gate coupled to the output end of the counter, an output end of NOT-gate coupled to a first input end of the first AND-gate, a second input end of the first AND-gate receives the sequence input signal.

7. The display panel according to claim 5, wherein the starting control module comprises a second AND-gate;
a first input end of the second AND-gate coupled to the output end of the counter, a second input of the second AND-gate receives the starting input signal.

8. A gate signal control method for display panel, wherein the display panel comprises a gate driving substrate, a plurality of driving units, and a level shifter; the gate driving substrate comprises a pixel array and a circuit laying area near the pixel array, the pixel array comprises pixel units arranged in rows; the plurality of gate driving units disposed on the circuit laying area for outputting scanning signals to the pixel units of the pixel array;
the control method comprises:
coupling an output end of the level shifter with the plurality of gate driving units, the level shifter being configured to generate sequence signals and a starting signal; and
making the sequence signals valid and making the starting signal invalid when the number of pulses of the sequence signals is less than a predetermined number; making the starting signal valid and making the sequence signals invalid when the number of pulses of the sequence signals reaches a predetermined number.

9. The gate signal control method for display panel according to claim 8, wherein the level shifter comprises a counter, a sequence control module and a starting control module;
the counter is configured to count the number of pulses of the sequence signals, and configured generate a control signal;
a first input end of the sequence control module coupled to an output end of the counter, for receiving the control signal and a sequence input signal, and for generating a sequence enable signal to output the sequence signals to the plurality of gate driving units;
a first input end of the starting control module coupled to the output end of the counter, for receiving the control signal and a starting input signal, and for generating a starting enable signal to output the starting enable signal to the plurality of gate driving units.

10. The gate signal control method for display panel according to claim 9, wherein the sequence control module comprises a NOT-gate and a first AND-gate;
an input end of the NOT-gate coupled to the output end of the counter, an output end of NOT-gate coupled to a first input end of the first AND-gate, a second input end of the first AND-gate receives the sequence input signal.

11. The gate signal control method for display panel according to claim 9, wherein the starting control module comprises a second AND-gate;
a first input end of the second AND-gate coupled to the output end of the counter, a second input of the second AND-gate receives the starting input signal.
